# EUROPEAN PATENT APPLICATION

(11) **EP 0 887 708 A2**
(43) Date of publication of application: **30.12.1998**
(21) Application number: 98305043.6
(22) Date of filing: 26.06.1998
(51) Int. Cl.: G03F 7/20

(54) **An exposure system**

(30) Priority: 26.06.1997 KR 9727525
(71) Applicant: Samsung Electronics Co., Ltd., Suwon-city, Kyungki-do (KR)
(72) Inventor: Kang, Ho-Young, Suwon, Kyunggi-do (KR)
(74) Representative: Tunstall, Christopher Stephen

(57) **Abstract**

Disclosed is an exposure system for transferring a pattern onto a wafer, which comprises a beam source for generating a light, a light transmitting portion and a projection optics. The light includes two mutually orthogonally polarised lights having a same amplitude. One of the polarised lights passes through a polarised light separating reflection prism and the other light reflects from the prism. At least one of the two polarised lights is delivered by the prism onto the wafer.

## Description

### Field of the Invention

The present invention relates to an exposure system and more particularly to an exposure system illuminating a surface of a wafer with light during a process for forming a semiconductor device.

### Background of the Invention

Optical lithography has used catadioptric systems including lenses and reflection mirrors. Catadioptric systems include systems using lenses alone and systems using a reflection mirror as a major component. In a system using lenses alone, attempts to utilise compounds such as calcium fluoride have been made to provide a narrow bandwidth of wavelength of approximately 0.1pm. However, as the bandwidth is restricted to not exceed 1pm, the system partially adopting reflection mirrors has been preferentially developed. To provide optical lithography compatible with the high integration density of a modern semiconductor device, the wavelength of the exposure light source in the catadioptric system should be reduced to less than 200nm. This leads to improved resolution of exposure.

The exposure system adopting a reflection mirror uses a polarised light separating reflection prism (e.g. a polarising beamsplitter). Since the prism of the exposure system has a high transmittance of light of wavelength greater than 200nm, stable exposure processing can be performed. However, when a wavelength of less than 200nm is used, the polarised light separating reflection prism of the exposure system absorbs heat. This entails a problem in that distortion occurs on the exposure wave-front. If the light passing through the prism heats the prism non-uniformly, there occur differences according to the positions through which the light is transmitted. These differences cause an aberration which is difficult to compensate. To suppress the aberration, a method exists for limiting an amount of light transmitted. However, this method has a problem in that the quantity of light arriving to expose the wafer, and so also the photo-lithographic yield (the efficiency of the exposure), is reduced. Due to the above-mentioned problems, it is difficult to realise an exposure system using light of wavelength less than 200nm.

### Summary of the Invention

In order to address the above-mentioned problems, it is desired to provide an exposure system capable of reducing light-induced distortion of a reflection plane of a polarised light separating reflection prism, while maintaining the photo-lithographic yield of the exposure system using light having a wavelength of less than 200nm at a similar level compared with that achieved in an exposure system using light having a wavelength of greater than 200nm.

Accordingly, the invention provides an exposure system comprising a beam source for generating a light; and projection optics for splitting the light into first and second polarised lights having a same amplitude and being mutually orthogonally polarised, and for delivering at least one of the first and second polarised lights onto a target.

Preferably, the projection optics comprises means for changing the path of at least one of the first and second polarised lights.

Preferably, the projection optics comprises means for changing the path of each of the first and second polarised lights.

Preferably, the projection optics comprises means for concentrating the first and second polarised lights.

Preferably, the projection optics comprises a polarised light separating reflection prism for passing one of the first and second polarised lights and reflecting the other of the first and second polarised lights.

Preferably, the projection optics comprises a first quarter waveplate for changing a polarisation direction of one of first and second polarised lights, so as to correspond to the polarisation direction of the second or first polarised light respectively.

Preferably, the projection optics comprises a first mirror for reflecting the polarised light passed through the first quarter waveplate to the polarised light separating reflection prism.

Preferably, the projection optics further comprises a second quarter waveplate for changing a polarisation direction of one of second and first polarised lights, so as to correspond to the polarisation direction of the first or second polarised light respectively.

Preferably, the projection optics comprises a second mirror for reflecting the polarised light passed through the second quarter waveplate to the polarised light separating reflection prism.

In a preferred embodiment of the invention, the beam source generates light of a single polarisation.

In such an embodiment of the invention, the exposure system preferably includes a polarisation plate for transforming the light of a single polarisation into light containing the first and second polarised lights.

Preferably, the projection optics comprises a reticle including a pattern desired to be transferred onto the target, the reticle being arranged such that the light passes therethrough.

Preferably, the light has a wavelength of less than 200nm.

Preferably, the target is a wafer.

Preferably, the projection optics comprises means for ensuring that total strengths of light in regions of the prism adjacent to a reflection plane of the prism are symmetrical about the reflection plane.

Preferably, the projection optics comprises means for ensuring that total strengths of light in regions of the prism are symmetrical about the reflection plane.

Preferably, the projection optics comprises means for ensuring that total strengths of light in regions of the prism are symmetrical about a plane perpendicular to the reflection plane.

Preferably, the exposure system of the invention further comprises a light delivery portion for adjusting, and changing a path of, the light.

The present invention also provides a method of exposing a target comprising the steps of generating light; splitting the light into first and second polarised lights having a same amplitude and being mutually orthogonally polarised; changing the path of at least one of the first and second polarised lights; and delivering at least one of the first and second polarised lights onto the target.

Preferably, the method further comprises the steps of passing first and second polarised lights through a polarised light separating prism; and ensuring that total strengths of light in regions of the prism adjacent to a reflection plane of the prism are symmetrical about the reflection plane.

Preferably, the method further comprises the steps of passing first and second polarised lights through a polarised light separating prism; and ensuring that total strengths of light in regions of the prism are symmetrical about a reflection plane of the prism.

Preferably, the method further comprises the steps of passing first and second polarised lights through a polarised light separating prism; and ensuring that total strengths of light in regions of the prism are symmetrical about a plane perpendicular to a reflection plane of the prism.

Preferably, the method further comprises the steps of adjusting and changing a path of the light.

### Brief Description of the Drawings

The present invention will be described in detail in respect of certain particular embodiments, given by way of examples, with reference to the accompanying drawings in which:
Fig. 1 shows an exposure system according to the present invention;
Fig. 2 shows a path of light in projection optics according to a first embodiment of the present invention;
Fig. 3 shows light in the polarised light separating reflection prism of Fig. 2;
Fig. 4 shows a path of light in projection optics according to a second embodiment of the present invention;
Fig. 5 shows a path of light in projection optics according to a third embodiment of the present invention; and
Fig. 6 is a diagram showing the path of light in projection optics according to a fourth embodiment of the present invention.

### Detailed Description of the Drawings

In the following description, corresponding reference labels indicate identical or corresponding features.

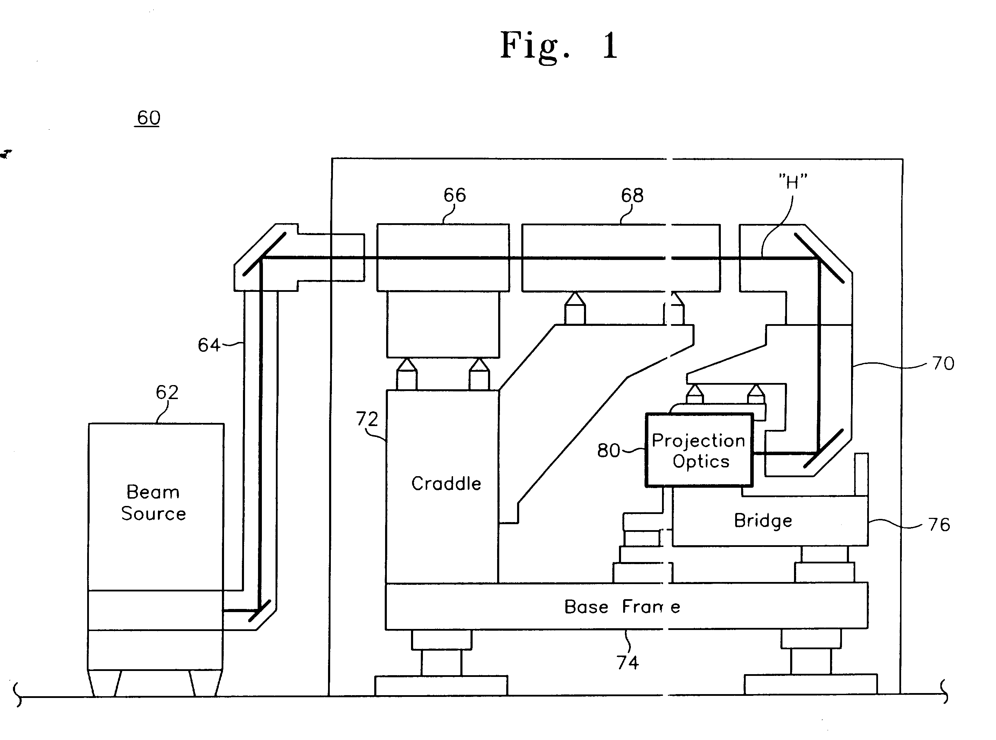

Referring to Fig. 1, an exposure system 60 of the present invention comprises a beam source 62, a beam supply 64, a beam conditioner 66, a beam condenser 68, a relay 70, projection optics 80, and a base frame 74. The beam source 62 generates light H to be used in the exposure process. The beam supply 64 transfers the light H generated in the beam source 62 in a pure nitrogen atmosphere. The beam conditioner 66 and the beam condenser 68 are coupled to the beam supply 64 and maintain the bonding strength and the homogeneity of the light H. The relay 70 transfers the light H to the projection optics 80. The beam conditioner 66 and the beam condenser 68 are supported by a cradle 72 of the base frame 74. The projection optics 80 are supported by bridge 76 of the base frame 74.

The beam source 62 generates the light H comprising a first polarised light and a second polarised light, each having a same amplitude and less than 200nm wavelength. The first and second polarised light are mutually orthogonally polarised.

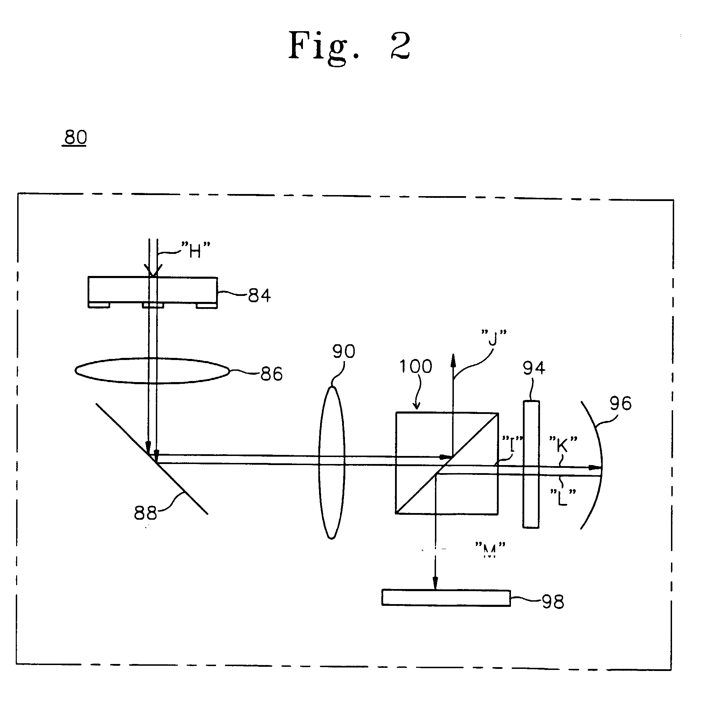

Fig. 2 is a diagram illustrating the path of the light in a projection optics according to a first embodiment of the present invention. Referring to Fig. 2 in the projection optics 80, a wafer 98 upon which an exposure process is to be performed, is loaded. The light H generated in the beam source 62 is provided to the projection optics 80 through a light delivery. The light delivery comprises the beam supply 64, a beam conditioner 66, a beam condenser 68 and a relay 70, shown in Fig. 1. The light H is split into the first polarised light I and the second polarised light J by means of the projection optics 80 and is at least partially delivered onto the surface of a target 98, such as a wafer.

The projection optics 80 comprises a reticle 84, lenses 86 and 90, a reflection mirror 88, a polarised light separating reflection prism 100, a first quarter waveplate 94, and a mirror 96. A pattern to be photolithographically transferred to the wafer 98 is formed on the reticle 84 at a predetermined magnification. The light H is provided from the light delivery to the wafer through the reticle 84. The pattern on the reticle is thereby transferred on to the wafer. The light H passes through the reticle 84 and is provided to the prism 100 by the lenses 86 and 90 and the reflection mirror 88. The lenses 86 and 90 and the reflection mirror 88 are used as a means for concentrating the light H and changing the path of the concentrated light to a predetermined direction, e.g. a direction perpendicular to the original direction of light H.

More specifically, the light H passed through the reticle 84 is concentrated by the lens 86. The path of light H is changed by the reflection mirror 88. The light from the reflection mirror 88 is again concentrated by the lens 90, and then provided to the prism 100. In the prism 100, the first polarised light I of the light H passes through the reflection plane of the prism 100, and the second polarised light J of the light H is reflected from the reflection plane, in a direction perpendicular to its original direction, i.e. upwards as represented in Fig. 2. The first polarised light I passes through the first quarter waveplate 94 which changes its polarisation direction. Thus, the polarisation direction of the changed first polarised light K becomes identical to that of the second polarised light J. The first polarised light K is reflected from mirror 96, as light L.

The reflected first polarised light L is reflected from the reflection plane of the prism 100 as light M. The light M performs the exposure process on the wafer 98.

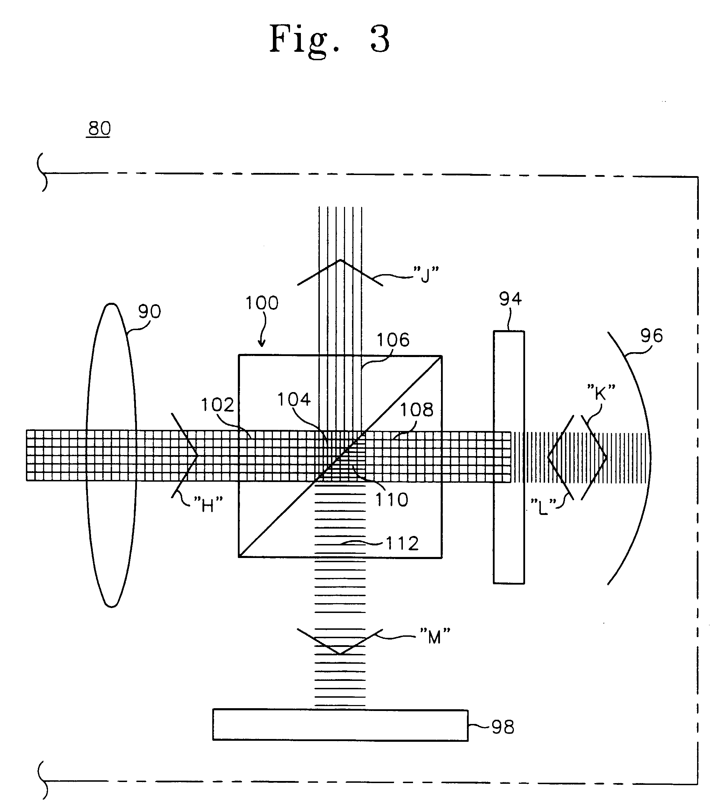

Fig. 3 is a diagram illustrating the path of light in the polarised light separating reflection prism 100 of Fig. 2.

Referring to Fig. 3, and according to an aspect of the invention, heat is symmetrically generated by light inside the prism 100. If the strength of the light in a first region 102 receiving the light H provided to the prism 100 is assumed to "2" (in arbitrary units), the total strength of the light in a second region 104 adjacent to the reflection plane of the prism 100 becomes "3". This is because, in the second region 104, the strength of the light H provided to the prism 100 is "2" and the strength of the second polarised light J reflected from the reflection plane is "1". The strength of light in a third region 106, formed by reflection of the second polarised light J, is "1".

Fourth to sixth regions 108, 110 and 112 are formed by the first polarised light I passing through the prism 100. In each of fourth to sixth regions the strengths of light are "2", "3" and "1", respectively.

In the fourth region 108, the strength "1" of the first polarised light passing through the prism 100 plus the strength "1" of the first polarised light L reflected by the mirror 96 back into the prism 100 equals a total strength of light of "2".

In the fifth region 110, the strength "1" of the first polarised light passing through the prism 100 plus the strength "1" of the first polarised light L reflected by the mirror 96 back into the prism 100 plus the strength "1" of the first polarised light M reflected by the prism 100 equals a total strength of light of "3".

The strength of light in the sixth region 112, formed by reflection of the light M, is "1".

Accordingly, since the strengths of light in the second region 104 and the fifth region 110 adjacent to the reflection place of the prism 100 are symmetrical, the heat generated by the light occurs symmetrically about the plane of reflection.

In addition, it will be noted that the strengths of light in third and sixth regions 106, 112 are equal, as are the strengths of light in first and fourth regions 102, 108. The equality of the light strengths in these regions adds further symmetry to the heating effect of light within the prism 100.

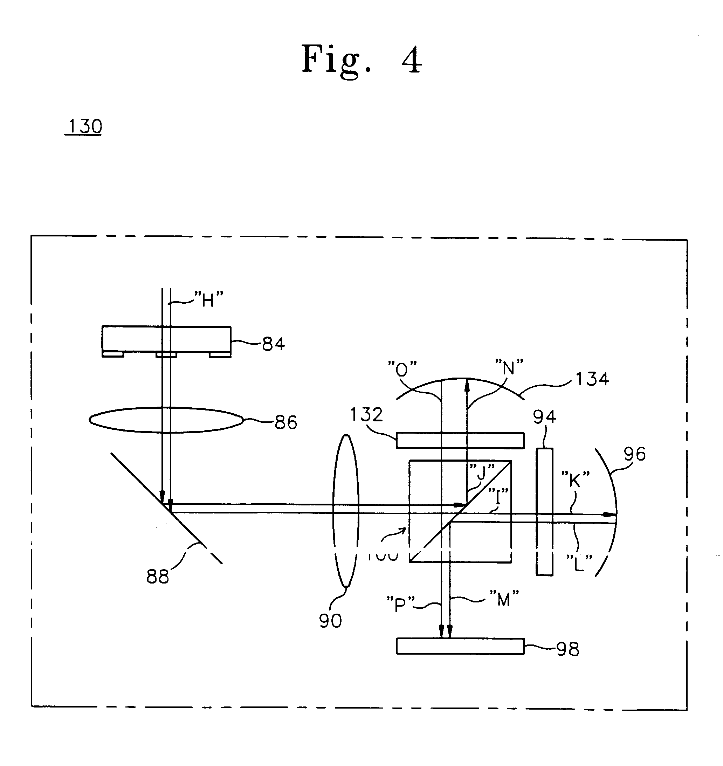

Fig. 4 shows a path of light in a projection optics 130 according to a second embodiment of the present invention.

Referring to Fig. 4, in a projection optics 130, both of the first and second polarised lights I, J of the light H provided to the prism 100 are delivered on to wafer 98. This differs from the projection options of Fig. 3 because the projection optics 130 is composed so as to deliver the second polarised light J reflected from the prism 100 to the wafer 98. In the projection optics 130, a second quarter waveplate 132 and a mirror 134 are installed in addition to the components of the projection optics 80 (Fig. 2). The second quarter waveplate 132 and the mirror 134 are installed on the path of the second polarised light J. The second quarter waveplate 132 changes the polarisation direction of the second polarised light J reflected from the prism 100. The changed polarisation direction is identical to that of the first polarised light I. The mirror 134 reflects the changed second polarised light N passed through the second quarter waveplate 132 to the prism 100. This reflected second polarised light O passes through the prism 100. The second polarised light P passed through the prism 100 is delivered on to the wafer 98 in the same manner in the first polarised light M, which is described above with reference to Fig. 2.

Accordingly, considering the strengths of light in various regions of the prism as discussed with reference to Fig. 3, in this second embodiment, the strengths of light in the second region 104 and the fifth region 110 adjacent to the reflection place of the prism 100 are both "4". Thus, the heat generated by the light in regions adjacent to the reflection plane occurs symmetrically about the plane of reflection.

In addition, it will be noted that the strengths of light in first and fourth, and third and sixth regions 102, 108, 106, 112 are all equal to "2". The equality of the light strengths in these regions adds further symmetry to the heating effect of light within the prism 100.

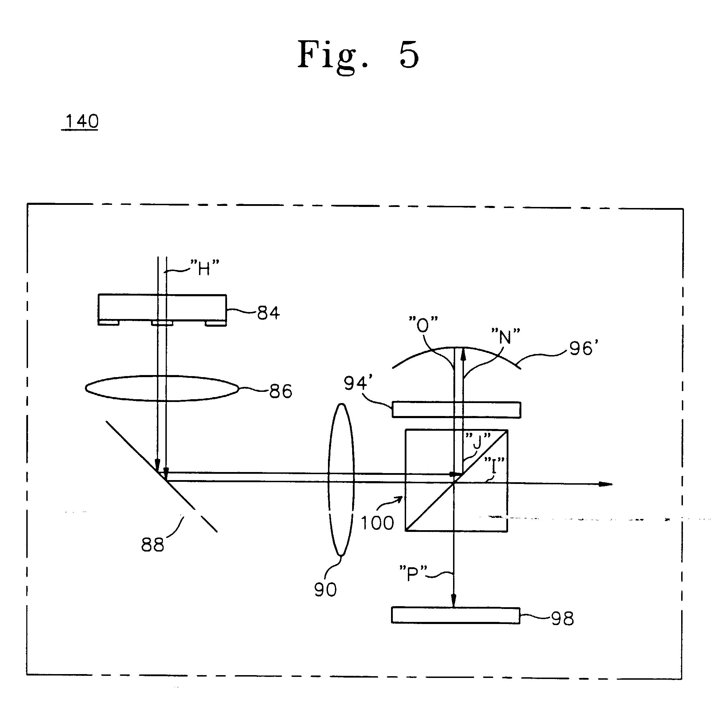

Fig. 5 is a diagram showing the path of light in a projection optics according to a third embodiment of the present invention.

Referring to Fig. 5, in a projection optics 140, first polarised light I passed through the prism 100 is not used to expose wafer 98. The projection optics 140 is composed so as to deliver only the second polarised light J reflected by the prism 100 and mirror 96' to the wafer 98. Accordingly, in the projection optics 140, quarter waveplate 94' and mirror 96' are installed to change the polarisation direction of, and to reflect, the second polarised light J reflected from the prism 100 (as light N) to the prism 100 again (as light O). The quarter waveplate 94' and the mirror 96' are installed on the path of the second polarised light J. No quarter wave plate or mirror 96 are provided on the path of first polarised light I. Detailed description of the components of the projection optics 140 and the method of exposing the wafer 98 with the second polarised light J is as described with reference to the second embodiment, and thus is not repeated.

Accordingly, considering the strengths of light in various regions of the prism as discussed with reference to Fig. 3, in this third embodiment, the strengths of light in the first and third regions 102, 106 are equal to "2". The strengths of light in the fourth and sixth regions 108, 112 are equal to "1". The equality of the light strengths in these pairs of regions adds symmetry to the heating effect of light within the prism 100, about a plane perpendicular to the reflection plane.

The first to third embodiments the present invention illustrate various configuration of the projection optics.

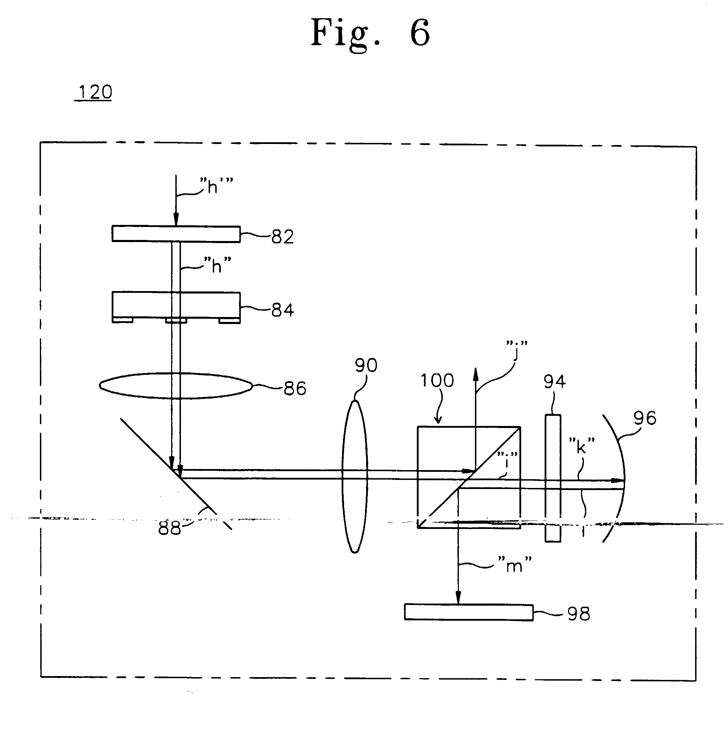

Fig. 6 is a diagram showing a path of light in a projection optics 120 according to a fourth embodiment of the present invention.

Referring to Fig. 6, light h' having a single polarisation is provided by a beam source to the projection optics 120, in themselves similar to projection optics 80 of Fig. 2. The light h' is transformed by a polarisation plate 82, preferably located adjacent to the reticle 84, set at an angle of 45° to the polarisation direction of light h'. Light h' is thereby transformed into light h comprising the first and the second polarised lights i, j being mutually orthogonally polarised and having a same amplitude. The strength of the light h is approximately half that of the former light h'. For example, when the strength of the light h' having a single polarisation is assumed to "2", the strength of the light comprising each of the first and second polarised lights i, j becomes "1". Detailed descriptions of the constitution and the exposure method are as described with reference to the first embodiment and thus are not repeated. The fourth embodiment corresponds to the first embodiment, shown in Fig. 2, except in respect of the generation of lights h', i, j.

Accordingly, considering the strengths of light in various regions of the prism as discussed with reference to Fig. 3, in this fourth embodiment, the strengths of light in the second and fifth regions 104, 110 adjacent to the reflection plane of the prism 100 are symmetrical, and equal to "3". Heat generated by the light therefore occurs symmetrically about the plane of reflection.

In addition, it will be noted that the strengths of light in third and sixth regions 106, 112 are equal to "1", and the strengths of light in first and fourth regions 102, 108 are equal to "2". The equality of the light strengths in these regions adds further symmetry to the heating effect of light within the prism 100.

The modifications to the optics represented by the second and third embodiments represented in Figs 4, 5, being the addition or removal of quarter wave plate and mirrors, may be applied to the embodiment of Fig. 6, to provide corresponding fifth and sixth embodiments.

According to the present invention, uniform absorption of heat is provided in a polarised light separating reflection prism. Thus, the exposure system of the invention reduces distortion of the exposure wavefront by the prism, so reducing the aberration of light according to positions through which the light is transmitted in the prism. Also, since the full intensity of the light H passing through the prism may be maintained (P+M), an exposure system using light with a wavelength of less than 200nm can maintain a photolithographic yield similar to that of the exposure system using light with a wavelength of more than 200nm.

Although the present invention has been described with reference to certain particular embodiments, many variations and modifications are possible. For example, the target 98 may be any target required to be exposed and is not limited to a semiconductor wafer, or indeed to any type of wafer.

Although the embodiments described include a light delivery portion and mirrors for changing the path of light H; h'; h, some or all of the means for changing the path of light may be omitted, depending on a preferred orientation of target, light source and reticle, if used.

Although the reticle appears after transformation of light h' by polarising plate 82 in the described fourth embodiment, the reticle may equally be placed before the polarising plate 82.

## Claims

1. An exposure system (60) comprising:
- a beam source (62) for generating a light (H, h', h); and
- projection optics (80) for splitting the light into first and second polarised lights (I, J; i, j) having a same amplitude and being mutually orthogonally polarised, and for delivering at least one of the first and second polarised lights onto a target (98).

2. An exposure system according to claim 1, wherein said projection optics comprises means for changing the path of at least one of the first and second polarised lights.

3. An exposure system according to claim 2, wherein said projection optics comprises means for changing the path of each of the first and second polarised lights.

4. An exposure system according to any preceding claim, wherein said projection optics comprises means for concentrating the first and second polarised lights (I, J; i, j).

5. An exposure system according to any preceding claim, wherein said projection optics comprises a polarised light separating reflection prism (100) for passing one of the first and second polarised lights and reflecting the other of the first and second polarised lights.

6. An exposure system according to any of claims 2-5, wherein said projection optics comprises a first quarter waveplate (94; 94') for changing a polarisation direction of one of first and second polarised lights (I, J; i, j), so as to correspond to the polarisation direction of the second or first polarised light (J, I; j, i) respectively.

7. An exposure system according to claim 6, wherein said projection optics comprises a first mirror (96; 96') for reflecting the polarised light passed through the first quarter waveplate to the polarised light separating reflection prism (100).

8. An exposure system according to claim 6, wherein said projection optics further comprises a second quarter waveplate (132) for changing a polarisation direction of one of second and first polarised lights (J, I; j, i), so as to correspond to the polarisation direction of the first or second polarised light (I, J; i, j) respectively.

9. An exposure system according to claim 8, wherein said projection optics comprises a second mirror (134) for reflecting the polarised light passed through the second quarter waveplate to the polarised light separating reflection prism (100).

10. An exposure system according to any preceding claim wherein the beam source generates light (h') of a single polarisation.

11. An exposure system according to claim 10 including a polarisation plate (82) for transforming the light (h') of a single polarisation into light (h) containing the first and second polarised lights (i, j).

12. An exposure system according to any preceding claim, wherein said projection optics comprises a reticle including a pattern desired to be transferred onto the target, the reticle being arranged such that the light (H; h'; h) passes therethrough.

13. An exposure system according to any preceding claim, wherein said light (H; h', h) has a wavelength of less than 200nm.

14. An exposure system according to any preceding claim, wherein the target (98) is a wafer.

15. An exposure system according to claim 5 wherein the projection optics comprises means for ensuring that total strengths of light in regions (104, 110) of the prism (100) adjacent to a reflection plane of the prism are symmetrical about the reflection plane.

16. An exposure system according to claim 15, wherein the projection optics comprises means for ensuring that total strengths of light in regions (102-112) of the prism (100) are symmetrical about the reflection plane.

17. An exposure system according to claim 5 wherein the projection optics comprises means for ensuring that total strengths of light in regions (102-112) of the prism (100) are symmetrical about a plane perpendicular to the reflection plane.

18. An exposure system according to any preceding claim, further comprising a light delivery portion (64-70, 82) for adjusting, and changing a path of, the light (H, h', h).

19. A method of exposing a target comprising the steps of:
- generating light (H, h', h);
- splitting the light into first and second polarised lights (I, J; i, j) having a same amplitude and being mutually orthogonally polarised;
- changing the path of at least one of the first and second polarised lights; and
- delivering at least one of the first and second polarised lights onto the target (98).

20. A method according to claim 19 further comprising the steps of:
- passing first and second polarised lights through a polarised light separating prism (100); and
- arranging for total strengths of light in regions (104, 110) of the prism adjacent to a reflection plane of the prism to be symmetrical about the reflection plane.

21. A method according to claim 19 further comprising the steps of:
- passing first and second polarised lights through a polarised light separating prism (100); and
- arranging for total strengths of light in regions (102-112) of the prism to be symmetrical about a reflection plane of the prism.

22. A method according to claim 19 further comprising the steps of:
- passing first and second polarised lights through a polarised light separating prism (100); and
- arranging for total strengths of light in regions (104, 110) of the prism to be symmetrical about a plane perpendicular to a reflection plane of the prism.

23. A method according to any of claims 19-22 further comprising the steps of adjusting and changing a path of the light (H, h', h).
